# EUROPEAN PATENT APPLICATION

(11) **EP 1 511 116 A1**
(43) Date of publication of application: **02.03.2005**
(21) Application number: 03730713.9
(22) Date of filing: 30.05.2003
(51) Int. Cl.: H01M 14/00, H01L 31/04

(54) **PHOTOELECTRIC TRANSDUCER**

(30) Priority: 04.06.2002 JP 2002163482
(71) Applicant: Nippon Oil Corporation, Tokyo 105-8412 (JP)
(72) Inventor: UCHIDA, Souichi,c/o NIPPON OIL CORPORATION, Yokohama-shi, Kanagawa 231-0815 (JP); KOBAYASHI, Masaaki,c/o NIPPON OIL CORPORATION, Yokohama-shi, Kanagawa 231-0815 (JP); NISHIKITANI, Yoshinori,c/o NIPPON OIL CORPORATION, Yokohama-shi, Kanagawa 231-0815 (JP)
(74) Representative: Modin, Jan
(86) International application number: PCT/JP2003/006819
(87) International publication number: WO 2003/103085

(57) **Abstract**

A photovoltaic device is provided which device comprises at least a semiconductor layer formed on a transparent electrically conductive substrate, an electrolyte layer, and a counter electrode. The counter electrode is composed of a substrate and an electrically conductive carbon layer formed thereon. The photovoltaic device which is excellent in performance and can be easily produced is provided due to the use of the counter electrode.

## Description

### [Filed of the Invention]

The present invention relates to photovoltaic devices suitable for photovoltaic power generation applications such as solar batteries.

### [Background of the Invention]

A photovoltaic device, so-called wet solar cell such as a dye sensitized solar cell has on one side an operative electrode arranged on a photosensitive layer side and on the other side a counter electrode, an electrolyte being disposed between these electrodes. For such a photovoltaic device, the counter electrode is an indispensable component to allow a redox reaction to progress smoothly, but the use of a metallic counter electrode has a drawback in that it is corroded by an electrolyte. Alternatively, although a glass with a transparent oxide conductive film, such as an SnO₂:F glass is generally used as a counter electrode, the use of such a counter electrode is required to have a precious metal exhibiting catalytic activity, such as platinum deposited on one surface of the electrode so as to bring the activation energy of the redox reaction down. However, in order to deposit a precious metal exhibiting catalytic activity such as platinum, vacuum deposition or sputtering operation requiring large-scale apparatuses must be conducted, and there are a lot of problems in industrial sense to be solved, such as those concerning production efficiency and yield.

On the other hand, the use of porous activated carbon for a counter electrode of a photovoltaic device which is different from that mentioned above has been proposed (H. Pettersson, T. Gruszecki, Solar Energy Mater. Solar Cells, vol. 70, pp 203 (2001)). This proposal had such restrictions in the production of the device that a porous layer must be specially provided between the operative electrode and the counter electrode and be sealed as it absorbs an electrolyte liquid. Alternatively, a method has been proposed in which electrically conductive particles and carbon material are mixed and pressurized to be formed into a counter electrode. However, the device obtained by this method had a low photoelectric conversion efficiency (H. Lindstrom, A. Holmberg, E. Magnusson, S. -E. Lindquist, L. Malmqvist, A. Hagfeldt, Nano Lett., vol. 1, pp 97 (2001)).

The present invention was made in view of the foregoing situations and intends to provide a novel counter electrode thereby being able to produce a photovoltaic device which has excellent characteristic performances and can be easily produced.

### [Disclosures of the Invention]

The present invention has been accomplished as a result of extensive studies conducted to overcome the above-described problems of the conventional products.

That is, the present invention relates to a photovoltaic device having a counter electrode comprising a substrate and an electrically conductive carbon layer formed thereon.

Furthermore, the present invention also relates to the photovoltaic device wherein the substrate is an electrically conductive substrate.

The present invention will be described in more detail below.

The counter electrode used in the present invention is composed of a substrate and an electrically conductive carbon layer (hereinafter referred to as "conductive carbon layer") formed thereon.

No particular limitation is imposed on the substrate to be used in the invention. The material, thickness, size, and shape of the substrate can be properly selected depending on the purposes. The substrate may or may not have conductivity. For example, the substrate may be a metal such as gold and platinum and also selected from colored or colorless glasses, wire-reinforced glasses, glass blocks, and colored or colorless transparent resins. Specific examples of such resins include polyesters such as polyethylene terephthalate, polyamides, polysulfones, polyethersulfones, polyether ether ketones, polyphenylene sulfides, polycarbonates, polyimides, polymethyl methacrylates, polystyrenes, cellulose triacetates, and polymethyl pentenes. The substrates used herein are those having a smooth surface at ordinary temperatures, which surface may be flat or curved or deformable with stress. Alternatively, in order to impart conductivity to the substrate, one of the surfaces thereof may be coated with a thin metal film of gold, silver, chromium, copper, or tungsten or a conductive film made of a metal oxide. Preferred examples of the metal oxide include those obtained by doping to a metal oxide of tin or zinc trace amounts of other metal elements, such as Indium Tin Oxide (ITO (In₂O₃:Sn)), Fluorine doped Tin Oxide (FTO (SnO₂:F)), and Aluminum doped Zinc Oxide (AZO (ZnO:Al)).

The thickness of the conductive film is usually from 10 nm to 10 µm and preferably from 100 nm to 2 µm. The surface resistance (resistivity) is usually from 0.5 to 500 Ω/sq and preferably from 2 to 50 Ω /sq. The conductive film may be formed on a substrate in any conventional manner such as vacuum deposition, ion plating, CVD, electron beam vacuum deposition, and sputtering.

The conductive carbon layer may be arranged on the above-described substrate or the conductive film formed thereon. No particular limitation is imposed on the form of the conductive carbon layer to be arranged. Therefore, the conductive carbon layer may be arranged in the form of mesh or stripe on the entire or a part of the substrate surface.

In the case of arranging the conductive carbon layer on a part of the substrate, the substrate is preferably that having conductivity. In this case, no particular limitation is imposed on the coverage rate (area ratio) of the conductive carbon layer against the substrate. However, the conductive carbon layer covers preferably 50 percent or more, more preferably 80 percent or more, and further more preferably 90 percent or more of the substrate with the objective of sufficient performances of the conductive carbon layer. No particular limitation is imposed on the mesh or stripe form. Therefore, the mesh or stripe may be formed by straight or curved lines. No particular limitation is imposed on the width of lines or the size of mesh, which, therefore, may be selected depending on the type of conductive material . The lines have a width of preferably from 1 µm to 10 mm and particularly preferably from 2 µm to 5 mm and are spaced at intervals of usually from 1 µm to 10 cm and preferably from 2 µm to 5 cm.

The thickness of the conductive carbon layer is usually from 1 µm to 1 mm and preferably from 2 µm to 0.5 mm.

The conductivity (electric conductivity) of the conductive carbon layer is usually 200 Ω/sq or lower and preferably 20 Ω/sq or lower.

No particular limitation is imposed on conductive carbon materials forming the conductive carbon layer as long as they have conductivity suitable for the present invention. Examples of the materials include black lead or graphite, glassy carbon, acetylene black, Ketjen black, carbon fiber, activated carbon, petroleum coke, fullerenes such as C60 and C70, and single or multi layered carbon nanotube. Preferred are black lead and carbon fiber. No particular limitation is imposed on the shape of conductive carbon materials as long as they can be eventually formed into a carbon layer. Therefore, the material may be in the form of powder, discontinuous or continuous fiber, or woven or non-woven cloth.

In the case of using a powder material, it is preferably that having an adequate specific surface area. The specific surface area is preferably from 100 to 2,000 m²/g and more preferably from 300 to 1,000 m²/g. The average particle size is from 5 to 1,000 nm and preferably from 8 to 200 nm.

The conductive carbon layer may be composed of only any of the above-described conductive carbon materials but may contain another optional component as long as the object of the present invention can be achieved.

For example, a binder is preferably used for purpose of enhancing the conductivity through a raw material such as carbon powder or discontinuous or continuous fiber. No particular limitation is imposed on such a binder as long as it is inactive to and not electrolyzed in an electrolyte after being cured. Examples of such a binder include polymeric solid electrolytes, epoxy resins, acrylic resins, melamine resins, silicone resins, polytetrafluoro ethylene, polystyrol, carboxymethyl cellulose, polyvinylidene fluoride, derivatives of these compounds, and mixtures of any of these compounds. When any of these binders is used, the mix ratio of conductive carbon material/binder (mass ratio) is usually from 10/90 to 90/10 and preferably from 20/80 to 80/20.

Examples of other optional components include metal fine particles having properties that they are not corroded with an electrolyte and conductive oxide semiconductors such as ITO, FTO, and AZO.

No particular limitation is imposed on the method of forming the conductive carbon layer. Therefore, any conventional method may be used. For example, in the case of using a binder, the conductive carbon layer is formed by a method wherein any of the above-described conductive carbon materials and a binder are mixed and formed into paste and then printed on a surface of a substrate by a special printing technique such as screen printing, surface printing, gravure printing, intaglio printing, flexographic printing, or letterpress printing or a method wherein any of the above-described conductive carbon materials and a binder are mixed and formed into paste and then filled into grooves having been formed on a substrate beforehand and excess paste is removed with a spatula. After the paste is coated on a surface of a substrate, it may be heated so as to improve the conductivity or adhesivity. Heating may be conducted with an oven, a muffle furnace, or an electric furnace or utilizing infrared heating. Although the heating temperature is varied depending on the type of paste or substrate to be used, it is preferably from 50°C to 700°C, more preferably from 100°C to 600°C, and further more preferably from 200°C to 500°C. If necessary, heating may be conducted under a nitrogen atmosphere. Alternatively, any of the conductive carbon materials shaped into a thin film, a woven or non-woven cloth, a felt or a paper-like sheet may be laminated on a substrate.

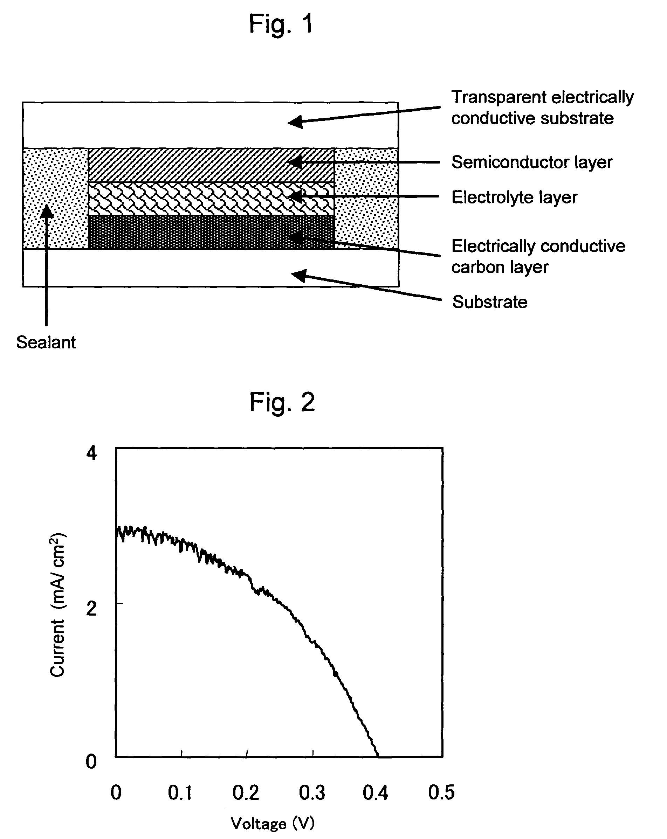

The photovoltaic device of the present invention is characterized by using the counter electrode thus obtained and essentially comprises a transparent conductive substrate, a photovoltaic layer (semiconductor layer) formed thereon, and the counter electrode. Although the photovoltaic layer may be in direct contact with the counter electrode, an electrolyte layer is usually arranged therebetween. Examples of the photovoltaic device include those having a structure as shown in Fig. 1.

No particular limitation is imposed on the electrolyte. Therefore, the electrolyte may be of liquid or solid type and is preferably that exhibiting reversible electrochemical oxidation-reduction characteristics.

The electrolyte is that having an ion conductivity of generally 1 x 10⁻⁷ S/cm or higher, preferably 1 x 10⁻⁶ S/cm or higher, and more preferably 1 x 10⁻⁵ S/cm or higher, at room temperatures. The ion conductivity can be sought by a conventional method such as complex impedance method.

The electrolyte used in the present invention are those whose oxidized form has a diffusion coefficient of 1 x 10⁻⁹ cm²/s or higher, preferably 1 x 10⁻⁸ cm²/s or higher, and more preferably 1 x 10⁻⁷ cm²/s or higher. The diffusion coefficient is one of the indices indicating ion conductivity and can be sought by any of conventional techniques such as a constant potential current characteristics measurement and a cyclic voltammogram measurement.

No particular limitation is imposed on the thickness of the electrolyte layer. The thickness is preferably 1 µm or more, more preferably 10 µm or more and preferably 3 mm or less and more preferably 1 mm or less.

No particular limitation is imposed on the liquid type electrolyte. The electrolyte is usually composed of a solvent, a substance exhibiting reversible electrochemical oxidation-reduction characteristics and dissoluble in the solvent, and if necessary a supporting electrolyte, as essential components.

The solvent may be any solvent as long as it is generally used for electrochemical cells or electric batteries. Specific examples of the solvent include acetic anhydride, methanol, ethanol, tetrahydrofuran, propylene carbonate, nitromethane, acetonitrile, dimethylformamide, dimethylsulfoxide, hexamethylphosphoamide, ethylene carbonate, dimethoxyethane, γ-butyrolactone, γ-valerolactone, sulfolane, propionnitrile, glutaronitrile, adiponitrile, methoxyacetonitrile, methoxypropionitrile, dimethylacetoamide, methylpyrrolidinone, dioxolane, trimethyl phosphate, triethyl phosphate, tripropyl phosphate, ethyldimethyl phosphate, tributyl phosphate, tripentyl phosphate, trihexyl phosphate, triheptyl phosphate, trioctyl phosphate, trinonyl phosphate, tridecyl phosphate, tris(trifluoromethyl)phosphate, tris(pentafluoroethyl)phosphate, triphenylpolyethylene glycol phosphate, and polyethylene glycol. Particularly preferred examples include propylene carbonate, ethylene carbonate, dimethylsulfoxide, dimethoxyethane, acetonitrile, γ-butyrolactone, sulfolane, dioxolane, dimethylformamide, tetrahydrofuran, adiponitrile, methoxyacetonitrile, methoxypropionitrile, dimethylacetoamide, methylpyrrolidinone, trimethyl phosphate, and triethyl phosphate. One of these solvents may be used alone or two or more of the solvents may be used in the form of a mixture.

The substance exhibiting reversible electrochemical oxidation-reduction characteristics is generally referred to as a redox agent. No particular limitation is imposed on the type of the redox agent. Examples of the substance include ferrocene, p-benzoquinone, 7,7,8,8-tetracyanoquinodimethane, N,N,N',N'-tetramethyl-p-phenylenediamine, tetrathiafulvalene, thianthracene, and p-toluylamine. The substance may also be LiI, NaI, KI, CsI, CaI₂, iodine salts of quaternary imidazolium, iodine salts of tetraalkylammonium, Br₂, and metal bromides such as LiBr, NaBr, KBr, CsBr or CaBr₂. Further, the substance may be tetraalkylammoniumbromide, bipyridiniumbromide, bromine salts, complex salts such as ferrocyanic acid-ferricyanate, sodium polysulfide, alkylthiol-alkyldisulfide, hydroquinone-quinone, or a viologen dye.

Only either one of an oxidized form or a reduced form may be used as the redox agent. An oxidized form and a reduced form may be added in the form of a mixture mixed at a suitable molar ratio. Alternatively, an oxidation-reduction pair may be added such that the electrolyte exhibits electrochemical response properties. Examples of materials exhibiting such properties include metallocenium salts such as ferrocenium having a counter anion selected from halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻ and halogens such as iodine, bromine, and chlorine.

Examples of substances exhibiting a reversible electrochemical oxidation-reduction characteristics include salts having a counter anion (X⁻) selected from halogen ions and SCN⁻. Examples of such salts include quaternary ammonium salts such as (CH₃)₄N⁺X⁻, (C₂H₅)₄N⁺X⁻, (n-C₄H₉)₄N⁺X⁻, and those represented by the following formulas: 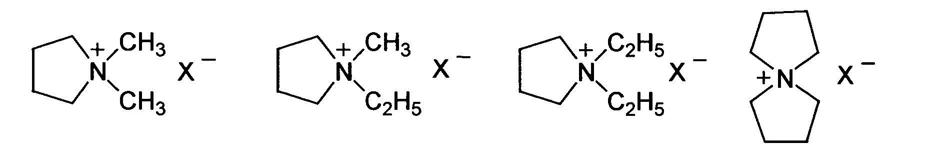 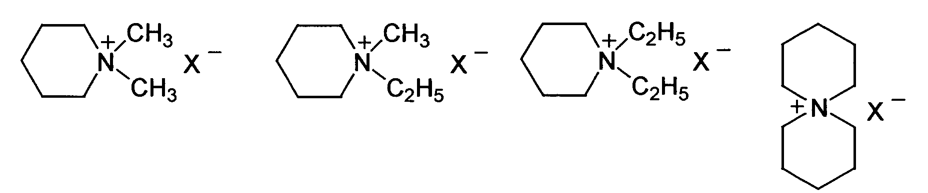 and phosphonium salts such as (CH₃)₄P⁺X⁻, (C₂H₅)₄P⁺X⁻, (C₃H₇)₄P⁺X⁻, and (C₄H₉)₄P⁺X⁻.

Needless to mention, mixtures of these compounds may be suitably used.

Redox ordinary-temperature melting salts may also be used as the substance exhibiting a reversible electrochemical oxidation-reduction characteristics. The term "redox ordinary-temperature melting salt" denotes a solvent-free salt comprising only ion pairs, in a melted state (liquid state) at ordinary temperature, more specifically denotes a salt comprising ion pairs which salt has a melting point of 20 °C or below and will be in a liquid state at a temperature exceeding 20 °C and are capable of inducing a reversible electrochemical oxidation-reduction reaction.

One type of redox ordinary-temperature melting salts may be used alone, or two type or more thereof may be used in the form of a mixture.

Examples of the redox ordinary-temperature melting salt include those represented by the following formulas: 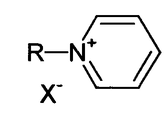 wherein R is an alkyl group having 2 to 20, preferably 2 to 10 carbon atoms and X⁻ is a counter anion such as a halogen ion or SCN⁻; 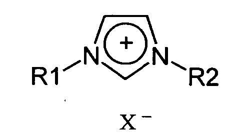 wherein R1 and R2 are each independently an alkyl group having 1 to 10 carbon atoms, preferably methyl or ethyl or an aralkyl group having 7 to 20, preferably 7 to 13 carbon atoms, preferably benzyl and may be the same or different from each other and X⁻ is a counter anion such as a halogen ion or SCN⁻; 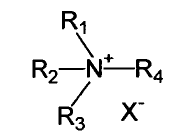 wherein R₁, R₂, R₃, and R₄ are each independently an alkyl group having one or more carbon atoms, preferably 1 to 6 carbon atoms, an aryl group having 6 to 12 carbon atoms such as phenyl, or a methoxymethyl group and may be the same or different from each other and X⁻ is a counter anion such as a halogen ion or SCN⁻.

No particular limitation is imposed on the amount of the substance exhibiting reversible electrochemical oxidation-reduction characteristics to be used as long as it is dissolved in any of the above-described solvents. However, the substance is used in an amount of 1 to 50 percent by mass and preferably 3 to 30 percent by mass based on the solvent.

The supporting electrolyte to be added if necessary may be salts, acids, alkalis, ordinary-temperature melting salts which are generally used in the field of electrochemistry or electric batteries.

No particular limitation is imposed on the salts. For example, the salts may be inorganic ion salts such as alkali metal salts and alkaline earth metal salts, quaternary ammonium salts, cyclic quaternary ammonium salts, and quaternary phosphonium salts. Particularly preferred are Li salts.

Specific examples of the salts include Li, Na, and K salts having a counter anion selected from ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻.

The salts may also be any of quaternary ammonium salts having a counter anion selected from ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻, more specifically (CH₃)₄N⁺BF₄⁻, (C₂H₅)₄N⁺BF₄⁻, (n-C₄H₉)₄N⁺BF₄⁻, (C₂H₅)₄N⁺Br⁻, (C₂H₅)₄N⁺ClO₄⁻, (n-C₄H₉)₄N⁺ClO₄⁻, CH₃(C₂H₅)₃N⁺BF₄⁻, (CH₃)₂(C₂H₅)₂N⁺BF₄⁻, (CH₃)₄N⁺SO₃CF₃⁻, (C₂H₅)₄N⁺SO₃CF₃⁻, (n-C₄H₉)₄N⁺SO₃CF₃⁻, and those represented by the following formulas: 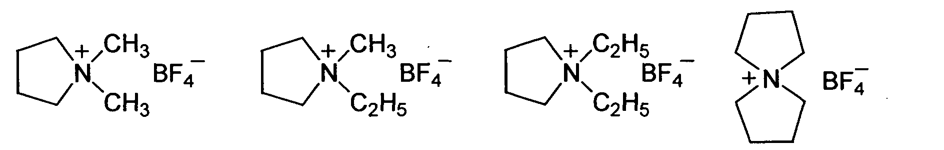 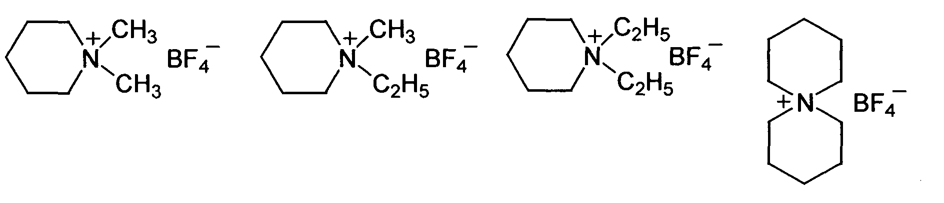 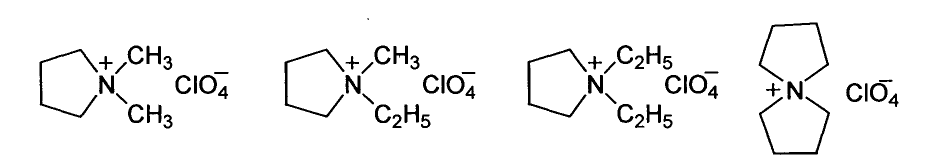 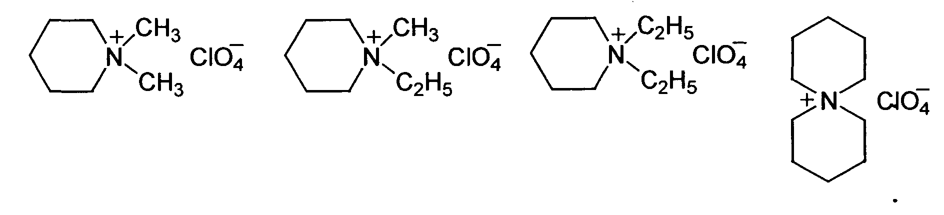 Furthermore, the salts may be any of phosphonium salts having a counter anion selected from ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻. More specific examples include (CH₃)₄P⁺BF₄⁻, (C₂H₅)₄P⁺BF₄⁻, (C₃H₇)₄P⁺BF₄⁻, and (C₄H₉)₄P⁺BF₄⁻.

Mixtures of these compounds may be suitably used in the present invention.

No particular limitation is imposed on the acids, which, therefore, may be inorganic acids or organic acids. Specific examples of the acids are sulfuric acid, hydrochloric acid, phosphoric acids, sulfonic acids, and carboxylic acids.

No particular limitation is imposed on the alkalis which, therefore, may be sodium hydroxide, potassium hydroxide, and lithium hydroxide.

No particular limitation is imposed on the ordinary-temperature melting salts. The ordinary-temperature melting salts used in the present invention are solvent-free salts comprising only ion pairs, in a melted state (liquid state) at ordinary temperature, more specifically salts comprising ion pairs which salts have a melting point of 20 °C or below and will be in a liquid state at a temperature exceeding 20 °C.

One type of the ordinary-temperature melting salts may be used alone or alternatively two or more thereof may be used in the form of a mixture.

Examples of the ordinary-temperature melting salt include those represented by the following formulas: 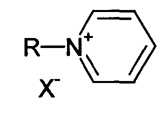 wherein R is an alkyl group having 2 to 20, preferably 2 to 10 carbon atoms and X⁻ is a counter anion selected from ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻; 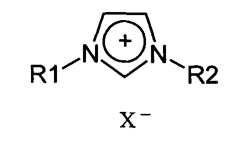 wherein R1 and R2 are each independently an alkyl group having 1 to 10 carbon atoms, preferably methyl or ethyl or an aralkyl group having 7 to 20, preferably 7 to 13 carbon atoms, preferably benzyl and may be the same or different from each other and X⁻ is a counter anion selected from ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻; and 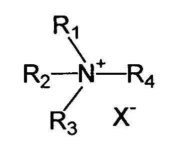 wherein R₁, R₂, R₃, and R₄ are each independently an alkyl group having one or more carbon atoms, preferably 1 to 6 carbon atoms, an aryl group having 6 to 12 carbon atoms such as phenyl, or a methoxymethyl group and may be the same or different from each other and X⁻ is a counter anion selected from ClO₄⁻, BF₄⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻.

No particular limitation is imposed on the amount of the supporting electrolyte to be used. The supporting electrolyte may be contained in an amount of usually 0.1 percent by mass or more, preferably 1 percent by mass or more, and more preferably 10 percent by mass or more and 70 percent by mass or less, preferably 60 percent by mass or less, and more preferably 50 percent by mass or less, in the electrolyte.

Although the above-described liquid electrolytes may be used as the electrolyte used in the present invention, polymeric solid electrolytes are particularly preferred because all the components of the photovoltaic device can be solid. Examples of particularly preferred polymeric solid electrolytes include those containing at least (c) a substance exhibiting reversible electrochemical oxidation-reduction characteristics (Component (c)) and if necessary further containing (b) a plasticizer (Component (b)), in (a) a polymeric matrix (Component (a)). In addition to these components, optional components such as (d) any of the above-described supporting electrolyte or (e) an ultraviolet adsorbing agent or an amine compound may be contained in the polymeric solid electrolyte if necessary. The polymeric solid electrolyte is formed in a solid or gelled state by Component (b) or Components (b) and (c) and/or additional optional components retained in Component (a), i.e., the polymeric matrix.

No particular limitation is imposed on materials usable for Component (a), i.e., polymeric matrix as long as they can be formed in a solid or gelled state by themselves or by addition of a plasticizer or a supporting electrolyte or the combination thereof. Polymeric compounds which have been generally used can be used in the present invention.

Examples of polymeric compounds exhibiting characteristics of the polymeric matrix include polymeric compounds obtained by polymerizing or copolymerizing a monomer such as hexafluoropropylene, tetrafluoroethylene, trifluoroethylene, ethylene, propylene, acrylonitrile, vinylidene chloride, acrylic acid, methacrylic acid, methylacrylate, ethylacrylate, methylmethacrylate, styrene, and vinylidene fluoride. Any one of these polymeric compounds may be used alone or a mixture of any of these compounds may be used. In the present invention, polyvinylidene fluoride-based polymeric compounds are particularly preferably used.

Examples of the polyvinylidene fluoride-based polymeric compounds include homopolymers of vinylidene fluoride and copolymers of vinylidene fluoride and another polymerizable monomer, preferably a radical polymerizable monomer. Examples of the another polymerizable monomer (hereinafter referred to as "copolymerizable monomer") to be copolymerized with vinylidene fluoride include hexafluoropropylene, tetrafluoroethylene, trifluoroethylene, ethylene, propylene, acrylonitrile, vinylidene chloride, acrylic acid, methacrylic acid, methylacrylate, ethylacrylate, methylmethacrylate, and styrene.

These copolymerizable monomers may be used in an amount of 1 to 50 percent by mol, preferably 1 to 25 percent by mol, based on the total mass of the monomer. The copolymerizable monomer is preferably hexafluoropropylene. The polymeric solid electrolyte preferably contains a vinylidene fluoride-hexafluoropropylene copolymer obtained by copolymerizing 1 to 25 percent by mol of hexafluoropropylene with vinylidene fluoride, as the polymeric matrix. A mixture of two or more types of vinylidene fluoride-hexafluoropropylene copolymers with different copolymerization ratios may also be used.

Alternatively, two or more of these copolymerizable monomers may be copolymerized with vinylidene fluoride. For example, copolymers may be used which copolymers are obtained by copolymerizing vinylidene fluoride, hexafluoropropylene and tetrafluoroethylene; vinylidene fluoride, hexafluoropropylene and acrylic acid; vinylidene fluoride, tetrafluoroethylene and ethylene; or vinylidene fluoride, tetrafluoroethylene and propylene.

Furthermore, in the present invention, the polymeric matrix may be a mixture of a polyvinyliden fluoride-based polymeric compound and one or more polymeric compounds selected from the group consisting of polyacrylic acid-based polymeric compounds, polyacrylate-based polymeric compounds, polymethacrylic acid-based polymeric compounds, polymethacrylate-based polymeric compounds, polyacrylonitrile-based polymeric compounds, and polyether-based polymeric compounds. Alternatively, the polymeric matrix may be a polyvinylidene fluoride-based polymeric compound may be a mixture of one or more copolymers obtained by copolymerizing a polyvinylidene fluoride-based polymeric compound with two or more monomers of the above-mentioned polymeric compounds. The blend ratio of the homopolymers or copolymers is usually 200 parts by mass or less, based on 100 parts by mass of the polyvinylidene fluoride-based polymeric compound.

In the present invention, preferred polyvinylidene fluoride-based polymeric compounds are those having a weight-average molecular weight of generally from 10,000 to 2,000,000, preferably from 100,000 to 1,000,000.

The plasticizer (Component (b)) acts as a solvent of a substance exhibiting reversible electrochemical oxidation-reduction characteristics. Any type of plasticizers may be used as long as it can be generally used as an electrolyte solvent for electrochemical cells or electric cells. Specific examples include various solvents exemplified with respect to the liquid electrolyte. Preferred examples include propylene carbonate, ethylene carbonate, dimethylsulfoxide, dimethoxyethane, acetonitrile, γ-butyrolactone, sulfolane, dioxolan, dimethylformamide, tetrahydrofuran, adiponitrile, methoxyacetonitrile, dimethylacetoamide, methylpyrrolidinone, trimethyl phosphate, and triethyl phosphate. Alternatively, ordinary-temperature melting salts may be used. The term "ordinary-temperature melting salt" used herein denotes a solvent-free salt comprising only ion pairs, in a melted state (liquid state) at ordinary temperature, more specifically a salt comprising ion pairs which salt has a melting point of 20 °C or below and will be in a liquid state at a temperature exceeding 20 °C.

Examples of the ordinary-temperature melting salt include those represented by the following formulas: 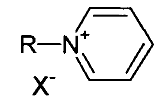 wherein R is an alkyl group having 2 to 20, preferably 2 to 10 carbon atoms and X⁻ is a halogen ion or SCN⁻; 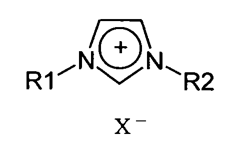 wherein R1 and R2 are each independently an alkyl group having 1 to 10 carbon atoms, preferably methyl or ethyl or an aralkyl group having 7 to 20, preferably 7 to 13 carbon atoms, preferably benzyl and may be the same or different from each other and X⁻ is a halogen ion or SCN⁻; 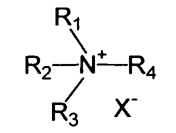 wherein R₁, R₂, R₃, and R₄ are each independently an alkyl group having one or more carbon atoms, preferably 1 to 6 carbon atoms, an aryl group having 6 to 12 carbon atoms such as phenyl, or a methoxymethyl group and may be the same or different from each other and X⁻ is a halogen ion or SCN⁻.

Any one of these plasticizers may be used alone or a mixture of two or more of these plasticizers may be used.

No particular limitation is imposed on the amount of the plasticizer to be used. The plasticizer may be contained in an amount of 20 percent by mass or more, preferably 50 percent by mass or more, and more preferably 70 percent by mass or more and 98 percent by mass or less, preferably 95 percent by mass or less, and more preferably 90 percent by mass or less, in the polymeric solid electrolyte.

Next described will be Component (c), i.e., substances exhibiting reversible electrochemical oxidation-reduction characteristics.

Component (c) is a compound capable of inducing the above-described reversible electrochemical oxidation-reduction reaction and is generally referred to as a redox agent.

No particular limitation is imposed on the type of such a compound. Examples of the compound include ferrocene, p-benzoquinone, 7,7,8,8-tetracyanoquinodimethane, N,N,N',N'-tetramethyl-p-phenylenediamine, tetrathiafulvalene, anthracene, and p-toluylamine. The compound may also be LiI, NaI, KI, CsI, CaI₂, iodine salts of quaternary imidazolium, iodine salts of tetraalkylammonium, Br₂, and metal bromides such as LiBr, NaBr, KBr, CsBr or CaBr₂.

Further, the compound may be tetraalkylammoniumbromide, bipyridiniumbromide, bromine salts, complex salts such as ferrocyanic acid-ferricyanate, sodium polysulfide, alkylthiol-alkyldisulfide, hydroquinone-quinone, or viologen. Only either one of an oxidized form or a reduced form may be used as the redox agent. An oxidized form and a reduced form may be added in the form of a mixture mixed at a suitable molar ratio.

Particular examples of Component (c) include salts having a counter anion (X⁻) selected from halogen ions and SCN⁻. Examples of such salts include quaternary ammonium salts such as (CH₃)₄N⁺X⁻, (C₂H₅)₄N⁺X⁻, (n-C₄H₉)₄N⁺X⁻, and those represented by the following formulas: 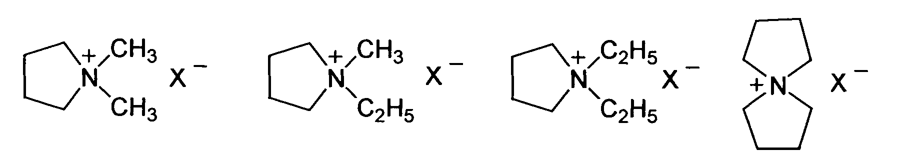 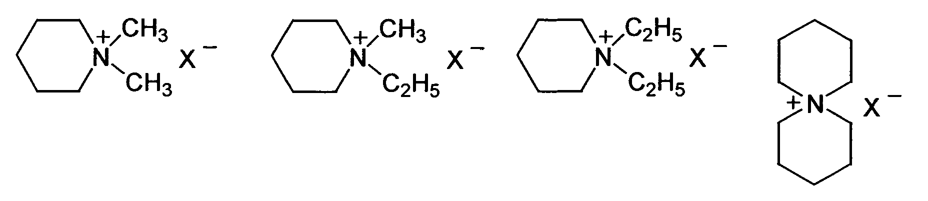 and phosphonium salts such as (CH₃)₄P⁺X⁻, (C₂H₅)₄P⁺X⁻, (C₃H₇)₄P⁺X⁻, and (C₄H₉)₄P⁺X⁻.

Needless to mention, mixtures of these compounds may be suitably used.

These compounds are preferably used in combination with Component (b).

Alternatively, a redox ordinary-temperature melting salt may be used as Component (c). The term "redox ordinary-temperature melting salt" denotes a solvent-free salt comprising only ion pairs, in a melted state (liquid state) at ordinary temperature, more specifically denotes a salt comprising ion pairs which salt has a melting point of 20 °C or below and will be in a liquid state at a temperature exceeding 20 °C and are capable of inducing a reversible electrochemical oxidation-reduction reaction. When the redox ordinary-temperature melting salt is used as Component (c) , Component (b) may or may not be used in combination.

One type of the redox ordinary-temperature melting salts may be used alone or alternatively two or more types of the salts may be used in the form of a mixture.

Examples of the redox ordinary-temperature melting salt include those represented by the following formulas: 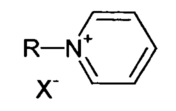 wherein R is an alkyl group having 2 to 20, preferably 2 to 10 carbon atoms and X⁻ is a halogen ion or SCN⁻; 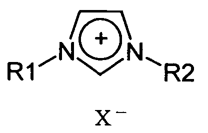 wherein R1 and R2 are each independently an alkyl group having 1 to 10 carbon atoms, preferably methyl or ethyl or an aralkyl group having 7 to 20, preferably 7 to 13 carbon atoms, preferably benzyl and may be the same or different from each other and X⁻ is a halogen ion or SCN⁻; 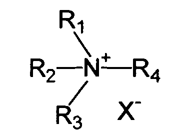 wherein R₁, R₂, R₃, and R₄ are each independently an alkyl group having one or more carbon atoms, preferably 1 to 6 carbon atoms, an aryl group having 6 to 12 carbon atoms such as phenyl, or a methoxymethyl group and may be the same or different from each other and X⁻ is a halogen ion or SCN⁻.

No particular limitation is imposed on the amount of Component (c). Component (c) may be generally contained in an amount of usually 0.1 percent by mass or more, preferably 1 percent by mass or more, and more preferably 10 percent by mass or more and 70 percent by mass or less, preferably 60 percent by mass or less, more preferably 50 percent by mass or less, in the polymeric solid electrolyte.

When Component (c) is used in combination with Component (b), the mix ratio is desirously selected such that Component (c) is dissolved in Component (b) and does not precipitate after being formed into the polymeric solid electrolyte. The mix ratio by mass of Component (c)/Component (b) is in the range of preferably 0.01 to 0.5 and more preferably 0.03 to 0.3.

The mass ratio of Component (a)/(Components (b) and (c)) is within the range of preferably 1/20 to 1/1, more preferably 1/10 to 1/2.

No particular limitation is imposed on the amount of the supporting electrolyte (Component (d)) to be used. The supporting electrolyte may be contained in an amount of usually 0.1 percent by mass or more, preferably 1 percent by mass or more, and more preferably 10 percent by mass or more and 70 percent by mass or less, preferably 60 percent by mass or less, and more preferably 50 percent by mass or less, in the polymeric solid electrolyte.

The polymeric solid electrolyte may further contain other components. Examples of other components include ultraviolet adsorbing agents and amine compounds. No particular limitation is imposed on eligible ultraviolet adsorbing agent. Typical examples of the ultraviolet adsorbing agent include organic ultraviolet adsorbing agents such as compounds having a benzotriazole molecule structure or a benzophenone molecule structure.

Examples of the compound having a benzotriazole molecule structure include those represented by formula (1) below:

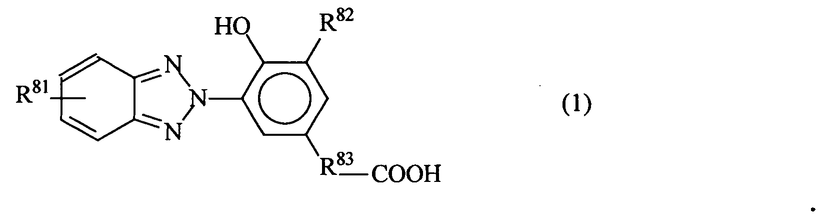

In formula (1), R⁸¹ is hydrogen, halogen or an alkyl group having 1 to 10, preferably 1 to 6 carbon atoms. Specific examples of the halogen are fluorine, chlorine, bromine, and iodine. Specific examples of the alkyl group include methyl, ethyl, propyl, i-propyl, butyl, t-butyl and cyclohexyl groups. R⁸¹ is usually substituted at the 4- or 5-position of the benzotriazole ring but the halogen and the alkyl group are usually located at the 4-position. R⁸² is hydrogen or an alkyl group having 1 to 10, preferably 1 to 6 carbon atoms. Examples of the alkyl group include methyl, ethyl, propyl, i-propyl, butyl, t-butyl, and cyclohexyl groups. R⁸³ is an alkylene or alkylidene group having 1 to 10, preferably 1 to 3 carbon atoms. Examples of the alkylene group include methylene, ethylene, trimethylene, and propylene groups. Examples of the alkylidene group include ethylidene and propylidene groups.

Specific examples of the compounds represented by formula (1) include 3-(5-chloro-2H-benzotriazole-2-yl)-5-(1,1-dimethylethyl)-4-hydroxy-benzene propanoic acid, 3-(2H-benzotriazole-2-yl)-5-(1,1-dimethylethyl)-4-hydroxy-benzene ethanoic acid, 3-(2H-benzotriazole-2-yl)-4-hydroxybenzene ethanoic acid, 3-(5-methyl-2H-benzotriazole-2-yl)-5-(1-methylethyl)-4-hydroxybenzene propanoic acid, 2-(2'-hydroxy-5'-methylphenyl)benzotriazole, 2-[2'-hydroxy-3',5'-bis(α,α-dimethylbenzyl) phenyl] benzotriazole, 2-(2'-hydroxy-3', 5'-di-t-butylphenyl)benzotriazol, 2-(2'-hydroxy-3'-t-butyl-5'-methylphenyl)-5-chloro benzotriazole, and 3-(5-chloro-2H-benzotriazole-2-yl)-5-(1,1-dimethyl ethyl)-4-hydroxy-benzene propanoic acid octylester.

Specific examples of the compound having a benzophenone molecule structure include those represented by the following formulas:

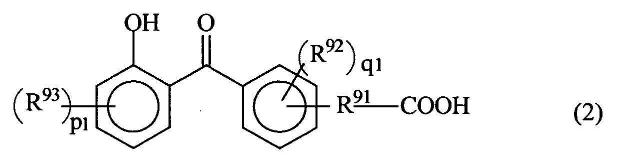

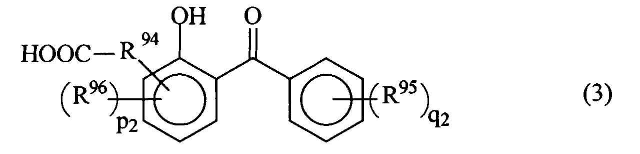

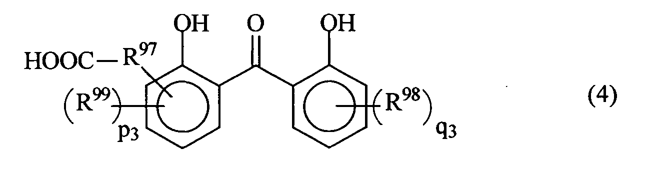

In formulas (2) to (4), R⁹², R⁹³, R⁹⁵, R⁹⁶, R⁹⁸, and R⁹⁹ may be the same or different from each other and are each independently a hydroxyl group or an alkyl or alkoxy group having 1 to 10, preferably 1 to 6 carbon atoms. Examples of the alkyl group include methyl, ethyl, propyl, i-propyl, butyl, t-butyl, and cyclohexyl groups. Specific examples of the alkoxy group are methoxy, ethoxy, propoxy, i-propoxy, and butoxy groups.

R⁹¹, R⁹⁴, and R⁹⁷ are each independently an alkylene or alkylidene group having 1 to 10, preferably 1 to 3 carbon atoms. Examples of the alkylene group include methylene, ethylene, trimethylene, and propylene groups. Examples of the alkylidene group include ethylidene and propylidene groups.

In the above formulas, p1, p2, p3, q1, q2, and q3 are each independently an integer of 0 to 3.

Preferred examples of the compounds having a benzophenone molecule structure, represented by formulas (2) to (4) include 2-hydroxy-4-methoxybenzophenone-5-carboxylic acid, 2,2'-dihydroxy-4-methoxybenzophenone-5-carboxylic acid, 4-(2-hydroxybenzoyl)-3-hydroxybenzen propanoic acid, 2,4-dihydroxybenzophenone, 2-hydroxy-4-methoxybenzophenone, 2-hydroxy-4-methoxybenzophenone-5-sulfonic acid, 2-hydroxy-4-n-octoxybenzophenone, 2,2'-dihydroxy-4,4'-dimethoxybenzophenone, 2,2',4,4'-tetrahydroxybenzophenone, and 2-hydroxy-4-methoxy-2'-carboxybenzophenone.

Needless to mention, two or more of these ultraviolet adsorbing agents may be used in combination.

The use of the ultraviolet adsorbing agent is optional. No particular limitation is imposed on the amount of the ultraviolet adsorbing agent to be used. However, if the agent is used, it may be contained in an amount of 0.1 percent by mass or more, preferably 1 percent by mass or more and 20 percent by mass or less and preferably 10 percent by mass or less, in the polymeric solid electrolyte.

No particular limitation is imposed on amine compounds which the polymeric solid electrolyte may contain. Various aliphatic and aromatic amines can be used. Typical examples of the amine compound include pyridine derivatives, bipyridine derivatives, and quinoline derivatives. It is expected that the open-circuit voltage is enhanced by addition of these amine compounds. Specific examples of these compounds include 4-t-butyl-pyridine, quinoline, and isoquinoline.

In the present invention, the electrolyte may be produced as a redox electrolyte film, and the method for producing the same will be described next.

The redox electrolyte film may be obtained by forming a mixture of Components (a) and (c) and optional components to be added if necessary into a film by a conventional method. No particular limitation is imposed on the film forming method, which, therefore, may be any of extrusion, casting, spin-coating, and dip-coating methods.

Extrusion may be conducted in a conventional manner wherein the mixture of the above-described components is formed into a film after being heat-melted.

Casting is conducted by adjusting the viscosity of the mixture by adding thereto a suitable diluent, and coating and drying the diluted mixture with a conventional coater normally used for casting thereby forming the mixture into a film. Examples of the coater include doctor coaters, blade coaters, rod coaters, knife coaters, reverse roll coaters, gravure coaters, spray coaters, and curtain coaters among which a suitable one is selected depending on the viscosity and film thickness.

Spin coating is conducted by adjusting the viscosity of the mixture by adding a suitable diluent, and coating and drying the diluted mixture with a commercially available spin-coater thereby forming the mixture into a film.

Dip coating is conducted by adjusting the viscosity of the mixture by adding a suitable diluent so as to obtain a solution of the mixture, dipping and lifting a suitable substrate therein, and drying the substrate thereby forming the mixture into a film.

No particular limitation is imposed on the semiconductor layer to be used in the photovoltaic device of the present invention. Examples of the semiconductor layer include those of Bi₂S₃, CdS, CdSe, CdTe, CuInS₂, CuInSe₂, Fe₂O₃, GaP, GaAs, InP, Nb₂O₅, PbS, Si, SnO₂, TiO₂, WO₃, ZnO, and ZnS, among which preferred are those of CdS, CdSe, CuInS₂, CuInSe₂, Fe₂O₃, GaAs, InP, Nb₂O₅, PbS, SnO₂, TiO₂, WO₃, and ZnO. These materials may be used in combination. Particularly preferred are those of TiO₂, ZnO, SnO₂, and Nb₂O₅, while most preferred are those of TiO₂ and ZnO.

The semiconductor used in the present invention may be monocrystalline or polycrystalline. For example, the crystal system may be selected from those of anatase, rutile, or brookite type among which preferred are those of anatase type. The semiconductor layer may be formed by any suitable conventional method.

The semiconductor layer may be obtained by coating a nanoparticle dispersant or sol solution, of the above-mentioned semiconductor on the substrate by any conventional method. No particular limitation is imposed on the coating method. Therefore, the coating may be conducted by a method wherein the semiconductor is obtained in the form of film by casting; spin-coating; dip-coating; bar-coating; and various printing methods such as screen-printing.

The thickness of the semiconductor layer may be arbitrarily selected but is 0.5 µm or more and 50 µm or less, and preferably 1 µm or more and 20 µm or less.

For purpose of enhancing the light-absorbing efficiency of the semiconductor layer, various dyes may be adsorbed to or contained in the layer.

No particular limitation is imposed on the dye to be used in the present invention as long as it can enhance the light-absorbing efficiency of the semiconductor layer. One or more of various metal complex dyes or organic dyes may be usually used. In order to improve the adsorptivity to the semiconductor layer, dyes having in their molecules a functional group such as carboxyl, hydroxyl, sulfonyl, phosphonyl, carboxylalkyl, hydroxyalkyl, sulfonylalkyl, and phosphonylalkyl groups are preferably used.

Eligible metal complex dyes are a complex of ruthenium, osmium, iron, cobalt, or zinc; metal phthalocyanine; and chlorophyll.

Examples of the metal complex dyes used in the present invention include those represented by the following formulas: 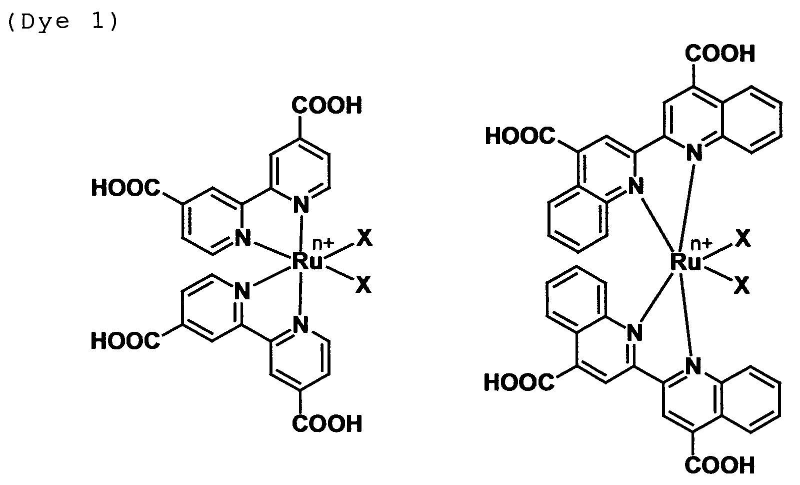 wherein X is a univalent anion and two X may be independent of each other or cross-linked and are any of those represented by the following formulas: 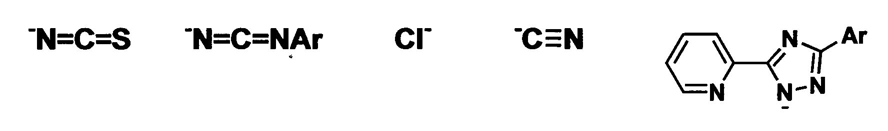 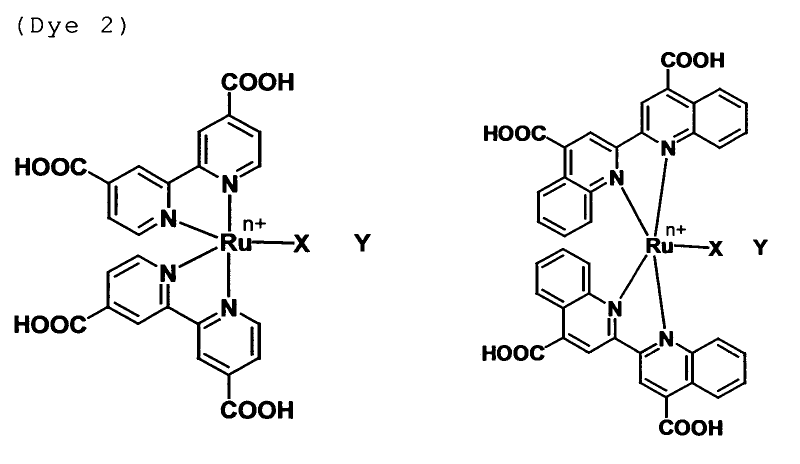 wherein X is a univalent anion and may be any of those represented by the following formulas: 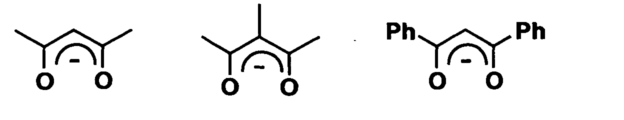 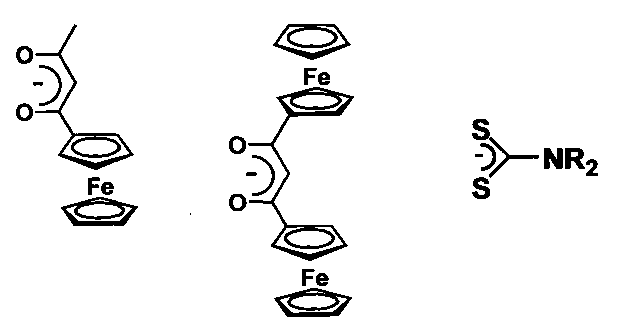 wherein Y is a univalent anion and may be any of halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻; 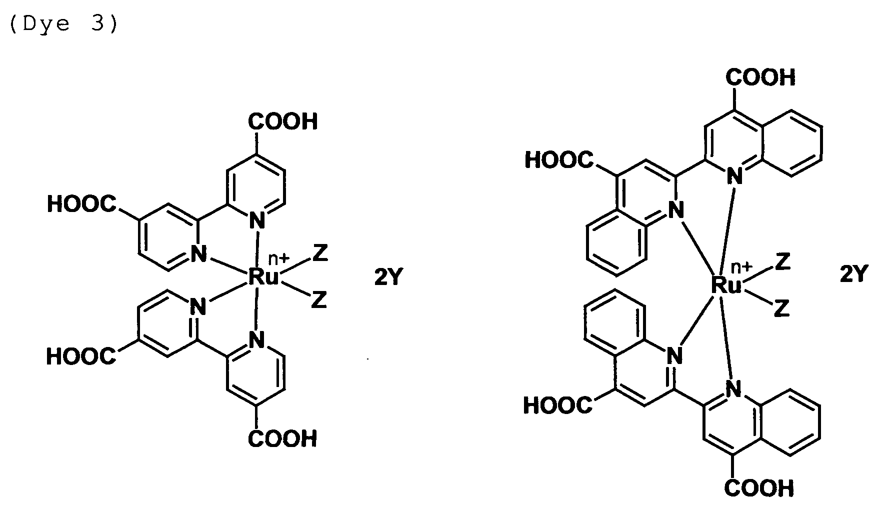 wherein Z is an atomic group having an unshared electron pair, and two Z may be independent of each other or cross-linked and any of those represented by the following formulas: 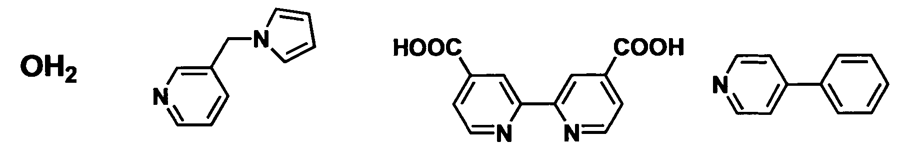 and Y is an univalent anion and may be any of halogen ions, SCN⁻, ClO₄⁻, BF₄⁻, CF₃SO₃⁻, (CF₃SO₂)₂N⁻, (C₂F₅SO₂)₂N⁻, PF₆⁻, AsF₆⁻, CH₃COO⁻, CH₃(C₆H₄)SO₃⁻, and (C₂F₅SO₂)₃C⁻; and

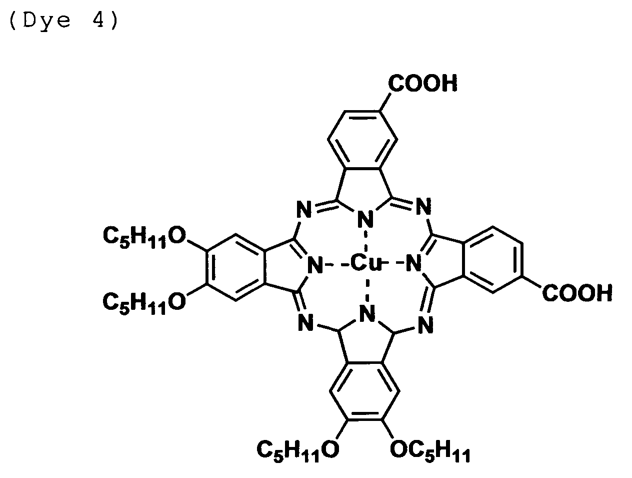

Eligible organic dyes are cyanine-based dyes, hemicyanine-based dyes, merocyanine-based dyes, xanthene-based dyes, triphenylmethane-based dyes, and metal-free phthalocyanine-based dyes.

Examples of the dyes used in the present invention include those represented by the following formulas:

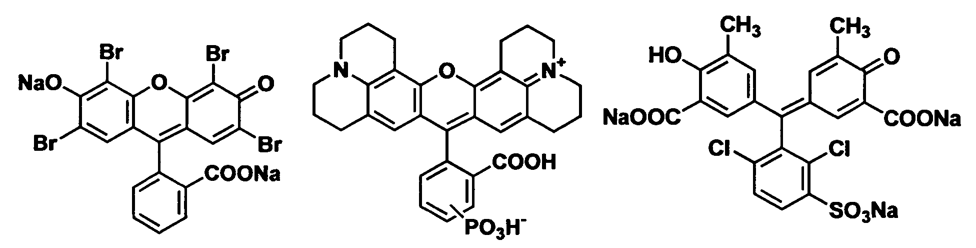

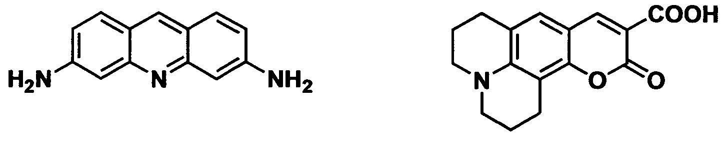

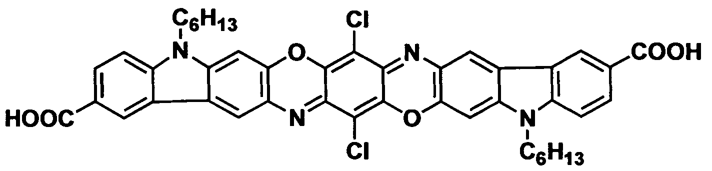

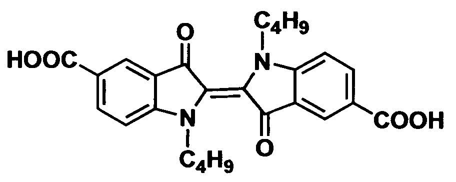

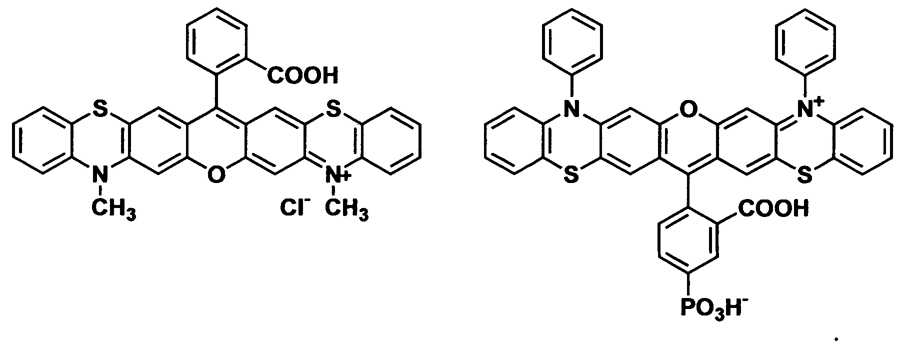

The dye may be adsorbed to the semiconductor layer on a transparent electrically conductive substrate by coating a solution obtained by dissolving the dye in a solvent on the semiconductor layer by spray- or spin-coating and drying the solution. In this case, the substrate may be heated to a suitable temperature. Alternatively, the dye may be adsorbed to the semiconductor layer by dipping the layer into the solution. No particular limitation is imposed on the time for dipping as long as the dye is sufficiently adsorbed to the semiconductor layer. The substrate is dipped into the solution for preferably 1 to 30 hours, particularly preferably 5 to 20 hours. If necessary, the solvent or the substrate may be heated upon dipping. The concentration of the dye in the solution is preferably from 1 to 1,000 mM/L and more preferably from 10 to 500 mM/L.

No particular limitation is imposed on the solvent to be used as long as it dissolves the dye but not the semiconductor layer. Examples of the solvent include alcohols such as methanol, ethanol, 1-propanol, 2-propanol, 1-butanol, 2-butanol, and t-butanol, nitrile-based solvents such as acetonitrile, propionitrile, methoxypropionitrile, and glutaronitrile, benzene, toluene, o-xylene, m-xylene, p-xylene, pentane, heptane, hexane, cyclohexane, heptane, ketones such as acetone, methyl ethyl ketone, diethyl ketone, and 2-butanone, diethylether, tetrahydrofuran, ethylene carbonate, propylene carbonate, nitromethane, dimethylformamide, dimethylsulfoxide, hexamethylphosphoamide, dimethoxyethane, γ-butyrolactone, γ-valerolactone, sulfolane, adiponitrile, methoxyacetonitrile, dimethylacetoamide, methylpyrrolidinone, dioxolan, trimethyl phosphate, triethyl phosphate, tripropyl phosphate, ethyldimethyl phosphate, tributyl phosphate, tripentyl phosphate, trihexyl phosphate, triheptyl phosphate, trioctyl phosphate, trinonyl phosphate, tridecyl phosphate, tris(trifluoromethyl)phosphate, tris(pentafluoroethyl)phosphate, triphenylpolyethylene glycol phosphate, and polyethylene glycol.

The transparent electrically conductive substrate (hereinafter referred to as "transparent conductive substrate") will be described next.

The transparent conductive substrate is produced by laminating a transparent electrode layer over a transparent substrate. No particular limitation is imposed on the transparent substrate. The material, thickness, size, and shape of the substrate can be properly selected depending on the purposes. For example, the substrate may be selected from colored or colorless glasses, wire-reinforced glasses, glass blocks, and colored or colorless transparent resins. Specific examples are polyesters such as polyethylene terephthalate, polyamides, polysulfones, polyethersulfones, polyether ether ketones, polyphenylene sulfides, polycarbonates, polyimides, polymethyl methacrylates, polystyrenes, cellulose triacetates, and polymethyl pentenes. The term "transparent" used herein denotes a transmissivity of 10 to 100 percent. The substrates used herein are those having a smooth surface at ordinary temperature, which surface may be flat or curved or deformed with stress.

No particular limitation is imposed on the transparent electrode layer acting as an electrode as long as it can achieve the purposes of the present invention. For example, the layer may be a thin metal film of gold, silver, chromium, copper, or tungsten or an electrically conductive film made of a metal oxide. Preferred examples of the metal oxide include those obtained by doping to tin oxide or zinc oxide trace amounts of components such as Indium Tin Oxide (ITO (In₂O₃:Sn)), Fluorine doped Tin Oxide (FTO (SnO₂:F)), and Aluminum doped Zinc Oxide (AZO (ZnO:Al)).

The film thickness is usually from 10 nm to 10 µm, preferably from 100 nm to 2 µm. The surface resistance (resistivity) is properly selected depending on the use of the substrate in the present invention, but is usually from 0.5 to 500 Ω/sq, preferably from 2 to 50 Ω/sq.

The photovoltaic device of the present invention may be used as a photovoltaic device having a cross-section as shown in Fig. 1. The device has a substrate A composed of a transparent substrate and a semiconductor layer (titania and dye layers) formed thereon and a conductive counter electrode (substrate B) composed of a substrate and a conductive carbon layer formed thereon. The space defined between the substrates A and B is filled with an electrolytes, and the peripheral space of the device is sealed with a sealant. Lead wires (not shown) are connected to the electrically conductive portions of substrates A and B to take out electromotive force.

No particular limitation is imposed on the method of producing the photovoltaic device of the present invention. In general, the photovoltaic device can be easily produced by a conventional method wherein the substrates A and B are sealed at their periphery and joined to each other with a predetermined space therebetween, and an electrolyte is put thereinto. The space between the substrates is generally 0.1 µm or larger and preferable 1 µm or larger and generally up to 1 mm and preferably 0.5 mm or smaller.

### [Applicabilities in the Industry]

A photovoltaic device with excellent durability can be provided at inexpensive material and production costs, using the counter electrode of the present invention. The resulting device is suitable for the use in solar batteries.

### [Best Mode of Carrying out the Invention]

The present invention will be described in more detail with reference to the following examples but are not limited thereto.

### (Example 1)

To 10 g of a thermosetting acrylic resin (product name "Acrydic" manufactured by DAINIPPON INK AND CHEMICALS, INCORPORATED) and 2.2 g of a melamine resin (product name "Bansemin" manufactured by Harima Chemicals, Inc.) were added 12 g of graphite (product name "USSP" manufactured by Nippon Graphite Industries, Ltd.). 24 g of ethylene glycol mono-n-butyl ether were added to and mixed with the mixture thereby preparing a conductive paste.

The resulting conductive paste was bar-coated substantially over the entire surface of a 5 cm square glass substrate and heat-cured at a temperature of 160 °C for 0.5 hour. Thereafter, the cured paste was calcined under a nitrogen atmosphere at a temperature of 500 °C for 3 hours thereby obtaining a counter electrode having a conductive carbon layer. The thickness and surface resistance of the carbon layer was 50 µm and 50 Ω/sq, respectively.

Ti-Nanoxide T manufactured by SOLARONIX was bar-coated over a 5 cm square SnO₂:F glass (transparent conductive glass obtained by forming an SnO₂:F film on a glass substrate) with a film resistivity of 30 Ω/sq and dried. When the transparent conductive glass substrate was bar-coated, some pieces of Scotch-tape were attached to the 5 mm-width sides of the glass such that the thickness of the Ti-Nanoxide T was made uniform. The coated substrate was calcined at a temperature of 500 °C for 30 minutes. The substrate was dipped into a ruthenium dye represented by the formula below /ethanol solution (3.0 x 10⁻⁴ mol/L) for 15 hours thereby forming a dye layer. The resulting glass substrate and the counter electrode obtained above were joined together. A propylene carbonate solution containing 0.3 mol/L lithium iodine and 0.03 mol/L iodine was infiltrated by capillary phenomenon to the contact portions of the substrate and the counter electrode, and the peripheries therebetween were sealed with an epoxy sealant. Lead wires were connected to the conductive layer portion of the transparent conductive substrate and the counter electrode.

A simulated sunlight was irradiated to the resulting cell so as to measure the current voltage characteristics. It was confirmed that the cell exhibited excellent photoelectric conversion characteristics as shown in Fig. 2.

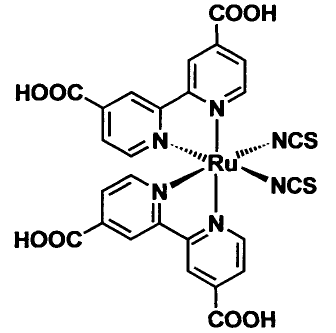

### (Example 2)

To 48 g of a thermosetting acrylic resin (product name "Acryl-G" manufactured by HONNY CHEMICAL CO., LTD. ) and 10 g of a melamine resin (product name "NIKALAC SM551" manufactured by Sanwa Chemical Co., Ltd.) were added 10 g of ketjen black (product name "ECP600JD" manufactured by MITSUBISHI CHEMICAL CORPORATION). 80 g of ethylene glycol mono-n-butyl ether were added to and mixed with the mixture thereby preparing a conductive paste.

The resulting conductive paste was bar-coated substantially over the entire surface of a 5 cm square glass substrate and heat-cured at a temperature of 160 °C for 0.5 hour. Thereafter, the cured paste was calcined under a nitrogen atmosphere at a temperature of 500 °C for 3 hours thereby obtaining a counter electrode having a conductive carbon layer. The thickness and surface resistance of the carbon layer was 50 µm and 55 Ω/sq, respectively.

Ti-Nanoxide T manufactured by SOLARONIX was bar-coated over a 5 cm square SnO₂:F glass (transparent conductive glass obtained by forming an SnO₂:F film on a glass substrate) with a film resistivity of 30 Ω/sq and dried. When the transparent conductive glass substrate was bar-coated, some pieces of Scotch-tape were attached to the 5 mm-width sides of the glass such that the thickness of the Ti-Nanoxide T was made uniform. The coated substrate was calcined at a temperature of 500 °C for 30 minutes. The substrate was dipped into a ruthenium dye (product name "Ruthenium-535-bisTBA" manufactured by Solaronix) /ethanol solution (5.0 x 10⁻⁴ mol/L) for 15 hours thereby forming a dye layer. The resulting glass substrate and the counter electrode obtained above were joined together. A 3-methoxypropionitrile solution containing 0.1 mol/L lithium iodine, 0.5 mol/L 1-propyl-2,3-dimethylimidazolium iodine, 0.5 mol/L 4-t-butylpyridine and 0.05 mol/L iodine was infiltrated by capillary phenomenon to the contact portions of the substrate and the counter electrode, and the peripheries therebetween were sealed with an epoxy sealant. Lead wires were connected to the conductive layer portion of the transparent conductive substrate and the counter electrode.

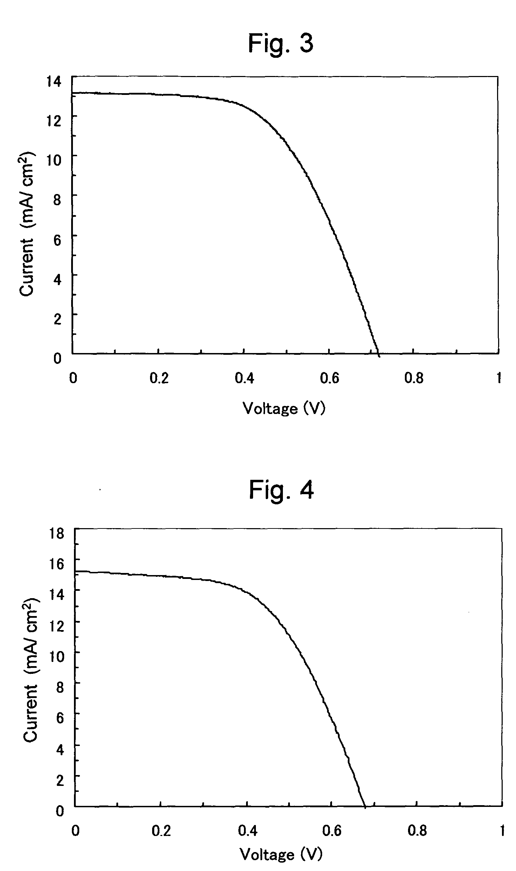

A simulated sunlight was irradiated to the resulting cell so as to measure the current voltage characteristics. It was confirmed that the cell exhibited excellent photoelectric conversion characteristics as shown in Fig. 3.

### (Example 3)

To 48 g of a thermosetting silicone resin (product name "RZ-7705" manufactured by Nippon Unicar Company Limited) were added 10 g of ketjen black (product name "ECP600JD" manufactured by MITSUBISHI CHEMICAL CORPORATION). 80 g of ethylene glycol mono-n-butyl ether were added to and mixed with the mixture thereby preparing a conductive paste.

The resulting conductive paste was bar-coated substantially over the entire surface of a 5 cm square glass substrate and heat-cured at a temperature of 160 °C for 0.5 hour. Thereafter, the cured paste was calcined under a nitrogen atmosphere at a temperature of 500 °C for 3 hours thereby obtaining a counter electrode having a conductive carbon layer. The thickness and surface resistance of the carbon layer was 50 µm and 35 Ω/sq, respectively.

Ti-Nanoxide T manufactured by SOLARONIX was bar-coated over a 5 cm square SnO₂:F glass (transparent conductive glass obtained by forming an SnO₂:F film on a glass substrate) with a film resistivity of 30 Ω/sq and dried. When the transparent conductive glass substrate was bar-coated, some pieces of Scotch-tape were attached to the 5 mm-width sides of the glass such that the thickness of the Ti-Nanoxide T was made uniform. The coated substrate was calcined at a temperature of 500 °C for 30 minutes. The substrate was dipped into a ruthenium dye (product name "Ruthenium-620-1H-3TBA" manufactured by Solaronix) /ethanol solution (5.0 x 10⁻⁴ mol/L) for 15 hours thereby forming a dye layer. The resulting glass substrate and the counter electrode obtained above were joined together. A 3-methoxypropionitrile solution containing 0.1 mol/L lithium iodine, 0.5 mol/L 1-propyl-2,3-dimethylimidazolium iodine, 0.5 mol/L 4-t-butylpyridine and 0.05 mol/L iodine was infiltrated by capillary phenomenon to the contact portions of the substrate and the counter electrode, and the peripheries therebetween were sealed with an epoxy sealant. Lead wires were connected to the conductive layer portion of the transparent conductive substrate and the counter electrode.

A simulated sunlight was irradiated to the resulting cell so as to measure the current voltage characteristics. It was confirmed that the cell exhibited excellent photoelectric conversion characteristics as shown in Fig. 4.

### [Brief Description of the Drawings]

Fig. 1 shows an example of the cross-section of a photovoltaic device.
Fig. 2 is a graph showing the current voltage characteristics of the photovoltaic device obtained in Example 1.
Fig. 3 is a graph showing the current voltage characteristics of the photovoltaic device obtained in Example 2.
Fig. 4 is a graph showing the current voltage characteristics of the photovoltaic device obtained in Example 3.

## Claims

1. A photovoltaic device wherein it has a counter electrode comprising a substrate and an electrically conductive carbon layer formed thereon.

2. A photovoltaic device comprising at least a transparent electrically conductive substrate, a semiconductor layer formed thereon, an electrolyte layer, a substrate, and an electrically conductive carbon layer formed thereon.

3. The photovoltaic device according claim 1 or 2, wherein said substrate is an electrically conductive substrate.

4. The photovoltaic device according claim 2, wherein said electrolyte layer is a polymeric solid electrolyte layer.

5. The photovoltaic device according claim 2, wherein said semiconductor layer contains a dye.
